# EUROPÄISCHE PATENTANMELDUNG

(11) **EP 2 698 677 A1**
(43) Veröffentlichungstag der Anmeldung: **19.02.2014**
(21) Anmeldenummer: 12180912.3
(22) Anmeldetag: 17.08.2012
(51) Int. Cl.: G05B 15/02

(54) **Peripheriesystem**

(71) Anmelder: Siemens Aktiengesellschaft, 80333 München (DE)
(72) Erfinder: Maier, Willi, 77728 Oppenau (DE); Pfatteicher, Werner, 76327 Pfinztal (DE); Rottmann, Norbert, 76829 Landau (DE); Bräunlich, Michael, 09117 Chemnitz (DE); Lohse, Ralf, 09387 Jahnsdorf (DE); Schmidt, Dirk, 08321 Zschorlau/OT Albernau (DE)

(57) **Zusammenfassung**

Die Erfindung betrifft ein Peripheriesystem mit mehreren über einen Bus verbundenen Baugruppen, von denen eine Baugruppe (1) erste Leitungsanschlüsse (8a bis 11a) und eine weitere Baugruppe (2) den ersten Leitungsanschlüssen (8a bis 11a) entsprechenden zweite Leitungsanschlüsse (8b bis 11b) aufweist, wobei die ersten und zweiten Leitungsanschlüsse (8a bis 11a; 8b bis 11b) Eingänge für Sensoren und/oder Ausgänge für Aktoren bilden. Dadurch, dass das Peripheriesystem einen Redundanz-Adapter (13, 17) zum direkten Kontaktieren mit den ersten und zweiten Leitungsanschlüssen aufweist, wobei der Redundanz-Adapter die ersten und zweiten Leitungsanschlüsse (8a bis 11a; 8b bis 11b) der beiden Baugruppen (1, 2) verschaltet und für die verschalteten Leitungsanschlüsse jeweils einen Anschluss (8c bis 11c) zum Anschließen eines elektrischen Leiters aufweist, kann die Verdrahtung der Prozessleitungen einfach, eindeutig und übersichtlich und schneller bewerkstelligt werden.

## Beschreibung

Die Erfindung betrifft ein Peripheriesystem mit mehreren über einen Bus verbundenen Baugruppen, von denen eine Baugruppe erste Leitungsanschlüsse und eine weitere Baugruppe den ersten Leitungsanschlüssen entsprechenden zweite Leitungsanschlüsse aufweist, wobei die ersten und zweiten Leitungsanschlüsse Eingänge für Sensoren und/oder Ausgänge für Aktoren bilden.

Ein derartiges Peripheriesystem ist aus dem Siemens-Katalog "ST PCS 7 - Juni 2012", Prozessleitsystem SIMATIC PCS 7, Seiten 8/49 bis 8/68 bekannt. Das Peripheriesystem ist mit einer Vielzahl von auf einen Träger montierbaren Baugruppen versehen und für die Anbindung der Prozessperipherie an ein oder mehrere Automatisierungsgeräte vorgesehen. Die Baugruppen umfassen gewöhnlich jeweils ein Grundmodul (Terminalmodul) sowie ein Elektronikmodul, z. B. ein Elektronikmodul in Form eines I/O-Moduls, welches auf das Grundmodul steckbar ist. Eine derartige Aufbautechnik mit so genannter "stehender Verdrahtung" unterstützt ein Ziehen und Stecken der I/O-Peripheriemodule in einem laufenden Betrieb. Dazu ist das jeweilige auf den Träger montierbare Grundmodul mit Leitungsanschlüssen bzw. Kanälen für die Verdrahtung von Prozessleitungen versehen, was bedeutet, dass an die jeweiligen Leitungsanschlüsse ein Sensor und/oder Aktor über eine geeignete Prozessleitung anschließbar ist.

Im Umfeld der Automatisierungstechnik werden verstärkt hochverfügbare Lösungen gefordert, welche geeignet sind, eventuell auftretende Stillstandszeiten der Anlage auf ein Minimum zu reduzieren. Dazu ist es erforderlich, sowohl neben der CPU bzw. Zentraleinheit eines Automatisierungsgerätes auch die Baugruppen des Peripheriesystems oder der Peripheriesysteme redundant auszubilden. Daher werden im Hinblick auf das Peripheriesystem zu verarbeitende Signale eines Sensors an zwei Baugruppen oder Steuersignale für einen Aktor gleichzeitig von zwei Baugruppen diesem Aktor übermittelt, wobei die Verdrahtung in der Art und Weise bewerkstelligt wird, dass ein Leitungsanschluss eines Grundmoduls einer Baugruppe mit dem entsprechenden bzw. identischen oder übereinstimmenden Leitungsanschluss eines Grundmoduls der anderen Baugruppe mittels einer Leitung verbunden bzw. kurzgeschlossen und an einen dieser beiden Leitungsanschlüsse die Sensor- oder Aktor-Leitung angeschlossen wird. Die Begriffe "entsprechend, identisch sowie übereinstimmend" beziehen sich in diesem Zusammenhang sowohl auf die Anzahl, die Positionierung, den Verwendungszweck als auch auf die mechanische und elektrische Ausbildung der Leitungsanschlüsse der Grundmodule.

Trotz dieser identisch bzw. übereinstimmend ausgebildeten Leitungsanschlüsse, welche die Eingänge für Sensoren oder die Ausgänge für Aktoren bilden, kann es aufgrund der Vielzahl der Leitungsanschlüsse ohne Weiteres im Rahmen der Installation zu Verdrahtungsfehlern kommen.

Der Erfindung liegt daher die Aufgabe zugrunde, in einem Peripheriesystem der eingangs genannten Art die Verdrahtung von Prozessleitungen zu vereinfachen.

Diese Aufgabe wird durch die im kennzeichnenden Teil des Anspruchs 1 angegebenen Maßnahmen gelöst.

Vorteilhaft ist, dass der Anschluss jeweils einer Prozessleitung an den Redundanz-Adapter ausreicht, um die jeweiligen Prozesssignale dem entsprechenden Ein- oder Ausgang beider Baugruppen zu übermitteln. Die Verdrahtung der Prozessleitungen ist einfach, eindeutig und übersichtlich und kann schneller bewerkstelligt werden. Im Hinblick auf die Leitungsanschlüsse zweier Standard-Baugruppen werden mittels des Redundanz-Adapters hochverfügbare Anschlüsse verwirklicht.

In einer Ausgestaltung der Erfindung ist vorgesehen, dass der Redundanz-Adapter einen ersten und einen zweiten Teil umfasst, welche über ein Kabel verbunden sind, wobei der erste oder zweite Teil mit den Leitungsanschlüssen zum Anschließen der elektrischen Leiter versehen ist. Dadurch ist es nicht erforderlich, dass die beiden Baugruppen benachbart angeordnet sein müssen. Eine der Baugruppen kann in einem Baugruppenträger und die andere in einem weiteren Baugruppenträger montiert werden.

In einer weiteren Ausgestaltung der Erfindung weist der Redundanz-Adapter für die jeweilig verschalteten Leitungsanschlüsse ein Anzeigemittel auf. Dieses zeigt einem Anwender ein aktives Prozesssignal an, wodurch eine Zuordnung der jeweiligen Leitungsanschlüsse zu den Prozesssignalen der angeschlossenen Sensoren und/oder Aktoren ermöglicht wird.

Eine geeignete Logik des Redundanz-Adapters ermöglicht es, in einem redundanten Betrieb der über den Bus verbundenen Baugruppen ohne Beeinflussung des Prozesses eine der beiden Baugruppen an den Bus anzuschließen oder eine der beiden Baugruppen von dem Bus zu trennen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figuren 1 und 4: Baugruppen eines Peripheriesystems und
- Figuren 2 und 3: einen Redundanz-Adapter.

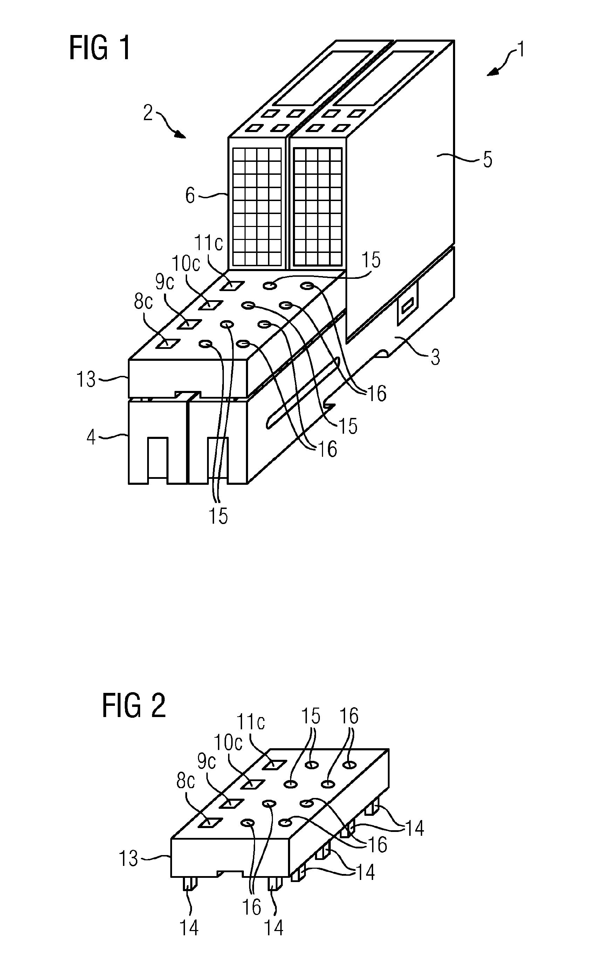

Die in den Figuren 1 bis 4 gleichen Teile sind mit gleichen Bezugszeichen versehen.

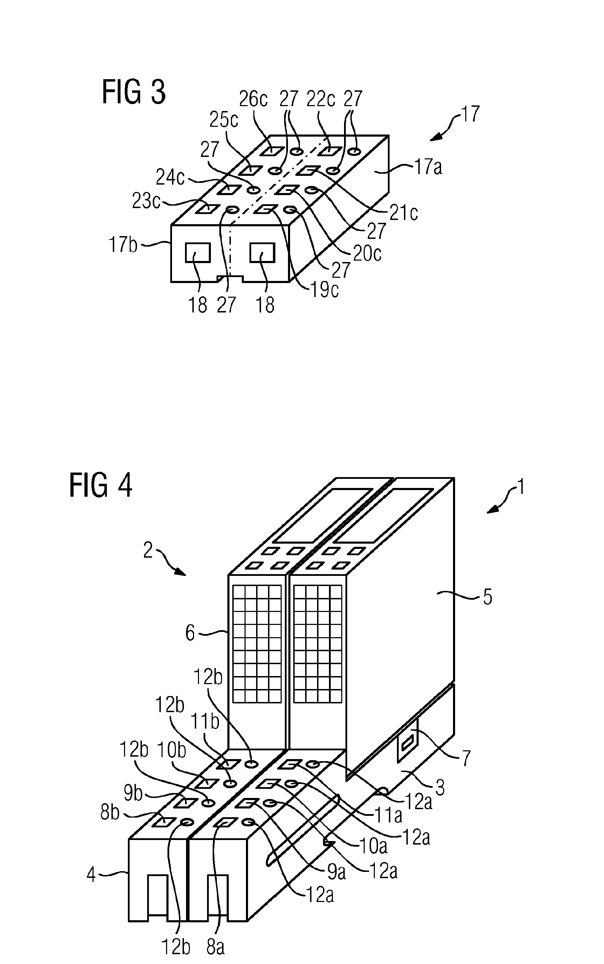

Es wird zunächst auf Figur 4 verwiesen, in welcher zwei auf einem hier nicht dargestellten Träger montierbare Baugruppen 1, 2 eines an sich bekannten Peripheriesystems dargestellt sind. Diese benachbart angeordneten Baugruppen 1, 2 weisen jeweils ein Grundmodul 3, 4 auf, welches z. B. mit einem Elektronikmodul in Form eines Eingabemoduls 5, 6 bestückt ist. Die benachbarten Grundmodule 3, 4 und somit die benachbarten Baugruppen 1, 2 sind über geeignete Busverbindungsmittel 7 miteinander verbunden. Jedes Grundmodul 3, 4 weist im vorliegenden Ausführungsbeispiel vier übereinstimmende Leitungsanschlüsse 8a bis 11a, 8b bis 11b zum Anschluss von vier hier nicht dargestellten Sensoren über Sensor-Leitungen auf, die mittels Schrauben 12a, 12b in den Leitungsanschlüssen 8a bis 11a, 8b bis 11b befestigt werden. Selbstverständlich können andere Verbindungstechniken, z. B. Federklemmen, zum Anschluss der Leitungen an die Grundmodule vorgesehen werden. Über geeignete elektrische Verbindungen der Grundmodule 3, 4 kontaktieren die jeweiligen Leitungsanschlüsse 8a bis 11a mit dem Eingabemodul 5 und die jeweiligen Leitungsanschlüsse 8b bis 11b mit dem Eingabemodul 6.

Um die vier Sensoren an die Leitungsanschlüsse der Grundmodule 3, 4 einfach anschließen zu können, ist ein Redundanz-Adapter 13 (Figuren 1 und 2) vorgesehen, welcher dazu ausgebildet ist, den Leitungsanschluss 8a über Kontakte 14 mit dem entsprechenden Leitungsanschluss 8b, den Leitungsanschluss 9a mit dem entsprechenden Leitungsanschluss 9b sowie die weiteren übereinstimmenden Leitungsanschlüsse 10a, 10b mit den Leitungsanschlüsse 11a, 11b zu verschalten bzw. zu verbinden. Dabei ist der im Wesentlichen quaderförmig ausgebildete Redundanz-Adapter 13 mit den Kontakten 14 auf die Leitungsanschlüsse 8a bis 11a, 8b bis 11b steckbar, wodurch der Redundanz-Adapter 13 direkt mit den Leitungsanschlüssen 8a bis 11a, 8b bis 11b kontaktiert. Für jeden der verschalteten bzw. verbundenen Leitungsanschlüsse weist der Redundanz-Adapter 13 einen Leitungsanschluss 8c bis 11c zum Anschluss einer der vier Sensoren auf, wobei der Redundanz-Adapter 13 mit Schraubverbindungen 15 oder sonstigen geeigneten Verbindungen zum Befestigen von Sensor-Leitungen in den Leitungsanschlüssen 8c bis 11c versehen ist. Für den Fall, dass z. B. ein Service-Techniker einen dieser Sensoren über eine Sensor-Leitung an den Leitungsanschluss 8c anschließt, wird mittels des Redundanz-Adapters 13 das Sensorsignal über Kontakte 14 des Redundanz-Adapters 13 sowohl dem Leitungsanschluss 8a des Grundmoduls 3 als auch dem Leitungsanschluss 8b des Grundmoduls 4 zugeführt, wodurch den Eingabemodulen 5, 6 die Sensorsignale zur weiteren Verarbeitung bereitgestellt werden. Für jeden der Leitungsanschlüsse 8c bis 11c des Redundanz-Adapters 13 ist ein Anzeigemittel 16 vorgesehen, das einem Anwender ein aktives Sensorsignal anzeigt, wodurch eine Zuordnung der jeweiligen Leitungsanschlüsse 8c bis 11c zum Sensorsignal der angeschlossenen Sensoren und/oder Aktoren ermöglicht wird.
Ferner ist der Redundanz-Adapter 13 für einen redundanten Betrieb der Baugruppen 1, 2 mit einer Logik zum Anschließen der Baugruppen 1, 2 an den Bus oder zum Trennen der Baugruppen 1, 2 vom Bus versehen, wobei in beiden Fällen der angeschlossene Prozess nicht beeinflusst wird.

In Figur 3 ist ein Redundanz-Adapter 17 dargestellt, der einen ersten Teil 17a und einen von diesem ersten Teil 17a trennbaren zweiten Teil 17b aufweist, wobei die beiden Teile 17a, 17b über an Verbindungsanschlüsse 18 anschließbare Leitungen bzw. Kabel verbindbar sind. Mittels eines derartigen Redundanz-Adapters 17 können nicht benachbart angeordnete Grundmodule redundant verschaltet werden. Auf jedes der Grundmodule ist ein Teil 17a, 17b steckbar, wobei z. B. Aktor-Leitungen entweder an Leitungsanschlüsse 19c bis 22c des Teils 17a oder an Leitungsanschlüsse 23c bis 26c des Teils 17b angeschlossen werden können. Für jeden der Leitungsanschlüsse 19c bis 22c, 23c bis 26c der Teile 17a, 17b ist wiederum ein Anzeigemittel 27 vorgesehen, das einem Anwender ein aktives Sensorsignal anzeigt.

Die Erfindung lässt sich daher wie folgt zusammenfassen: Ein Peripheriesystem mit mehreren über einen Bus verbundenen Baugruppen, von denen eine Baugruppe 1 erste Leitungsanschlüsse 8a bis 11a und eine weitere Baugruppe 2 den ersten Leitungsanschlüssen 8a bis 11a entsprechenden zweite Leitungsanschlüsse 8b bis 11b aufweist, wobei die ersten und zweiten Leitungsanschlüsse 8a bis 11a, 8b bis 11b Eingänge für Sensoren und/oder Ausgänge für Aktoren bilden, zeichnet sich dadurch aus, dass das Peripheriesystem einen Redundanz-Adapter 13, 17 zum direkten Kontaktieren mit den ersten und zweiten Leitungsanschlüssen 8a bis 11a, 8b bis 11b aufweist, wobei der Redundanz-Adapter 13, 17 die ersten und zweiten Leitungsanschlüsse 8a bis 11a, 8b bis 11b der beiden Baugruppen 1, 2 verschaltet und für die verschalteten Leitungsanschlüsse 8a bis 11a, 8b bis 11b jeweils einen Anschluss 8c bis 11c zum Anschließen eines elektrischen Leiters aufweist.

## Patentansprüche

1. Peripheriesystem mit mehreren über einen Bus verbundenen Baugruppen, von denen eine Baugruppe (1) erste Leitungsanschlüsse (8a bis 11a) und eine weitere Baugruppe (2) den ersten Leitungsanschlüssen (8a bis 11a) entsprechenden zweite Leitungsanschlüsse (8b bis 11b) aufweist, wobei die ersten und zweiten Leitungsanschlüsse (8a bis 11a; 8b bis 11b) Eingänge für Sensoren und/oder Ausgänge für Aktoren bilden, **dadurch gekennzeichnet, dass** das Peripheriesystem einen Redundanz-Adapter (13, 17) zum direkten Kontaktieren mit den ersten und zweiten Leitungsanschlüssen aufweist, wobei der Redundanz-Adapter die ersten und zweiten Leitungsanschlüsse (8a bis 11a; 8b bis 11b) der beiden Baugruppen (1, 2) verschaltet und für die verschalteten Leitungsanschlüsse jeweils einen Anschluss (8c bis 11c) zum Anschließen eines elektrischen Leiters aufweist.

2. Peripheriesystem nach Anspruch 1, **dadurch gekennzeichnet, dass** der Redundanz-Adapter (17) einen ersten und einen zweiten Teil (17a, 17b) umfasst, welche über ein Kabel verbunden sind, wobei der erste oder zweite Teil (17a, 17b) mit Anschlüssen (19c bis 22c, 23c bis 26c) zum Anschließen der elektrischen Leiter versehen ist.

3. Peripheriesystem nach Anspruch 1 oder 2, **dadurch gekennzeichnet, dass** der Redundanz-Adapter (13, 17) für den jeweiligen Anschluss (8c bis 11c, 19c bis 22c, 23c bis 26c) ein Anzeigemittel (16, 27) aufweist.

4. Peripheriesystem nach einem der Ansprüche 1 bis 3, **dadurch gekennzeichnet, dass** für einen redundanten Betrieb der Baugruppen (1, 2) der Redundanz-Adapter (13, 17) mit einer Logik zum Anschließen der Baugruppen (1, 2) an den Bus oder zum Trennen der Baugruppen (1, 2) vom Bus versehen ist.
